# EUROPÄISCHE PATENTSCHRIFT

(11) **EP 1 306 976 B1**
(45) Veröffentlichungstag und Bekanntmachung des Hinweises auf die Patenterteilung: **21.02.2007**
(21) Anmeldenummer: 02017984.2
(22) Anmeldetag: 10.08.2002
(51) Int. Cl.: H03K 19/003

(54) **Treiberschaltung zur Reduzierung von Rauschen in einem Ausgangspuffer**
Driver for reducing noise in an output buffer
Circuit d'attaque variable pour réduire le bruit dans un circuit tampon de sortie

(30) Priorität: 31.08.2001 DE 10142679
(43) Veröffentlichungstag der Anmeldung: 02.05.2003
(73) Patentinhaber: Infineon Technologies AG, 81669 München (DE)
(72) Erfinder: Kock, Ernst-Josef, Dr., 85614 Kirchseeon (DE); Rohm, Peter, 85276 Pfaffenhofen (DE)
(74) Vertreter: Repkow, Ines

(56) Entgegenhaltungen:
- EP-A- 0 533 340
- EP-A- 0 616 430
- EP-A- 0 952 668
- WO-A-02/03553
- WO-A-99/66336
- US-A- 5 149 991
- US-A- 5 285 116
- US-A- 5 319 260
- US-A- 5 650 736
- US-A- 5 949 254
- US-A- 5 958 026
- US-A- 6 157 204
- US-A- 6 163 178
- US-B1- 6 177 809
- US-B1- 6 208 177
- US-B1- 6 256 235
- PATENT ABSTRACTS OF JAPAN vol. 2000, no. 25, 12. April 2001 (2001-04-12) & JP 2001 211063 A (RICOH CO LTD), 3. August 2001 (2001-08-03)

## Beschreibung

Die vorliegende Erfindung betrifft eine Vorrichtung gemäß dem Oberbegriff des Patentanspruchs 1, d.h. eine Treiberschaltung mit einem Treiber und einer den Treiber steuernden Steuervorrichtung, wobei die Steuervorrichtung die Stärke des Treibers abhängig vom Verlauf des durch den Treiber zu treibenden Signals modifiziert.

Ein Treiber ist eine Schaltung, die aus einem ihr zugeführten Signal ein identisches, aber zum Treiben größerer Lasten geeignetes Signal erzeugt, und dieses ausgibt.

Treiber werden, um nur eine von nahezu unbegrenzt vielen Einsatzmöglichkeiten zu nennen, beispielsweise in Mikrocontrollern verwendet, um innerhalb des Mikrocontrollers erzeugte Daten aus dem Mikrocontroller auszugeben. Treiber werden aber auch in nahezu allen anderen existierenden integrierten Schaltungen verwendet.

Treiber sind seit vielen Jahren in unzähligen Ausführungsformen bekannt, so daß auf weitere Erläuterungen zum Aufbau und zur Funktion verzichtet werden kann.

Es ist ferner bekannt, die Treiber durch Steuervorrichtungen zu steuern. Dabei wird insbesondere die Stärke des Treibers an die gegebenen Verhältnisse angepaßt. Durch eine Anpassung des Treibers an die gegebenen Verhältnisse lassen sich der Stromverbrauch des Treibers und die von diesem erzeugten elektromagnetischen Störungen reduzieren.

Solche Treiberschaltungen sind z.B. aus US-A-5 149 991 bekannt.

Die Erfahrung zeigt jedoch, daß der Stromverbrauch der Treiber sowie die von diesen verursachten elektromagnetischen Störungen auch dann, wenn die Treiber durch Steuervorrichtungen an die gegebenen Verhältnisse angepaßt werden, immer noch relativ groß sind.

Der vorliegenden Erfindung liegt daher die Aufgabe zugrunde, die Treiberschaltung gemäß dem Oberbegriff des Patentanspruchs 1 derart weiterzubilden, daß der Stromverbrauch des Treibers sowie die vom Treiber verursachten elektromagnetischen Störungen weiter reduzierbar sind.

Diese Aufgabe wird erfindungsgemäß durch die in Patentanspruch 1 beanspruchte Treiberschaltung gelöst.

Die erfindungsgemäße Treiberschaltung zeichnet sich dadurch aus,
daß in der Leitung, über welche dem Treiber das zu treibende Signal zugeführt wird, ein Flip-Flop (OUT-FF) vorgesehen ist, welches das zu treibende Signal mit der steigenden oder fallenden Flanke eines Taktsignales (CLK) übernimmt und an den Treiber ausgibt,
und
daß die Steuervorrichtung mit dem Eingangsanschluß und dem Ausgangsanschluß des Flip-Flops verbunden ist und die Stärke des Treibers abhängig von den am Eingangsanschluß und am Ausgangsanschluß des Flip-Flops anliegenden Signalen modifiziert.

Dadurch ist es möglich,
- den Treiber in Phasen, in welchen sich das zu treibende Signal und/oder das vom Treiber ausgegebene Signal seinen Wert nicht ändert, ändern wird, oder ändern kann, in einen Zustand zu versetzen, in welchem er eine geringe Treiberstärke aufweist, und
- den Treiber in Phasen, in welchen sich das zu treibende Signal und/oder das vom Treiber ausgegebene Signal seinen Wert ändert, ändern wird, oder ändern kann, in einen Zustand zu versetzen, in welchem er eine höhere Treiberstärke aufweist.

Ein so angesteuerter Treiber verbraucht nicht mehr Energie und erzeugt nicht mehr Störungen als es unter den gegebenen Umständen unvermeidbar ist.

Vorteilhafte Weiterbildungen der Erfindung sind den Unteransprüchen, der folgenden Beschreibung, und den Figuren entnehmbar.

Die Erfindung wird nachfolgend anhand von Ausführungsbeispielen unter Bezugnahme auf die Figuren näher erläutert. Es zeigen
- Figur 1: ein erstes Ausführungsbeispiel der nachfolgend beschriebenen Treiberschaltung,
- Figur 2: ein zweites Ausführungsbeispiel der nachfolgend näher beschriebenen Treiberschaltung,
- Figur 3: eine Anordnung, durch welche die Treiberstärke stufenweise erhöht und/oder verringert werden kann, und
- Figur 4: ein Ausführungsbeispiel einer Treiberschaltung, welche nicht beansprucht wird.

Die im folgenden beschriebenen Treiberschaltungen sind Bestandteil eines Mikrocontrollers, können aber auch Bestandteil einer anderen programmgesteuerten Einheit wie beispielsweise eines Mikroprozessors oder eines Signalprozessors sein. Sie können auch Bestandteil einer beliebigen anderen integrierten Schaltung oder einer nicht integrierten Schaltung sein.

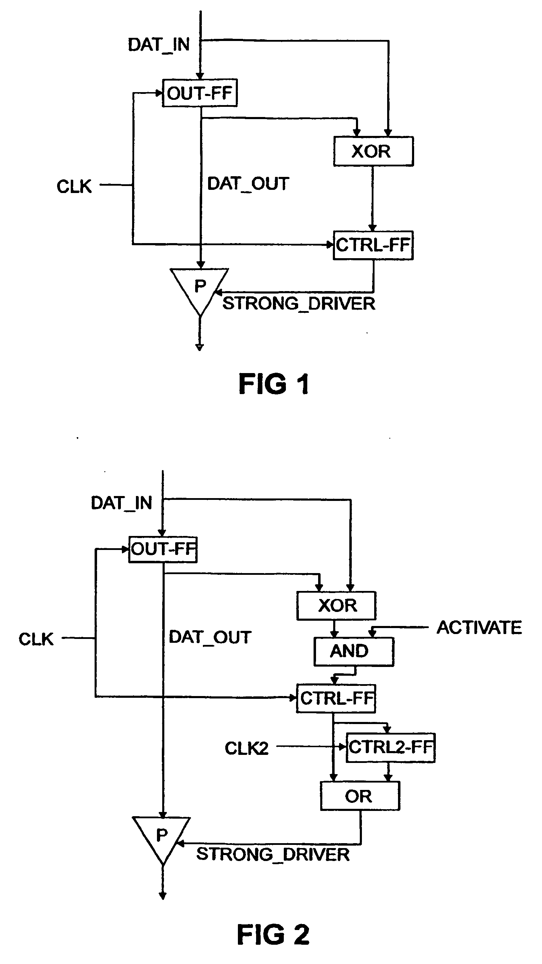

Das in der Figur 1 gezeigte erste Ausführungsbeispiel der vorliegend betrachteten Art von Treiberschaltungen enthält einen Treiber P, ein erstes Flip-Flop OUT-FF, ein XOR-Gatter XOR, und ein zweites Flip-Flop CTRL-FF.

Der Kern der gezeigten Treiberschaltung ist der Treiber P. Dieser bekommt vom ersten Flip-Flop OUT-FF ein in der Figur 1 mit DAT_OUT bezeichnetes Signal zugeführt, erzeugt daraus ein identisches, aber zum Treiben größerer Lasten geeignetes Signal, und gibt dieses aus. Die restlichen Komponenten der Treiberschaltung, d.h. das XOR-Gatter XOR, und das zweite Flip-Flop CTRL-FF bilden eine Steuervorrichtung, welche den Treiber P, genauer gesagt dessen Stärke abhängig vom Verlauf des diesem zugeführten Signals DAT_OUT steuern.

Dem ersten Flip-Flop OUT-FF wird ein digitales Eingangssignal DAT_IN zugeführt, welches vom ersten Flip-Flop OUT-FF mit der steigenden oder der fallenden Flanke eines Taktsignals CLK übernommen und als das bereits erwähnte Signal DAT_OUT an den Treiber P ausgegeben wird. Die Signale DAT_IN und DAT_OUT werden darüber hinaus dem XOR-Gatter XOR als Eingangssignale zugeführt. Das XOR-Gatter unterzieht die ihm zugeführten Signale einer XOR-Verknüpfung und gibt das Ergebnis an das zweite Flip-Flop CTRL-FF aus. Das zweite Flip-Flop übernimmt das ihm vom XOR-Gatter XOR zugeführte Signal mit der steigenden oder der fallenden Flanke des Taktsignals CLK und leitet es als ein den Treiber P steuerndes Signal STRONG_DRIVER an den Treiber P weiter.

Wenn und so lange das Signal STRONG_DRIVER der Wert 0 aufweist, was der Fall ist, wenn die Signale DAT_IN und DAT_OUT in der vorhergehenden Taktsignalperiode den selben Wert aufwiesen, wird der Treiber P durch das Signal STRONG_DRIVER in einen Zustand versetzt, in welchem er eine geringe Treiberstärke aufweist. Wenn und so lange das Signal STRONG_DRIVER der Wert 1 aufweist, was der Fall ist, wenn die Signale DAT_IN und DAT_OUT in der vorhergehenden Taktsignalperiode verschiedene Werte aufwiesen, wird der Treiber P durch das Signal STRONG_DRIVER in einen Zustand versetzt, in welchem er eine hohe Treiberstärke aufweist.

Dies hat den Effekt,
- daß der Treiber P gleichzeitig mit dem Eintreten einer Veränderung des Pegels des ihm zugeführten Signals in einen Zustand versetzt wird, in welchem er eine hohe Treiberstärke aufweist,
- daß der Treiber P für eine Taktsignalperiode in diesem Zustand gehalten wird, und
- daß der Treiber P
   - dann, wenn nach der Veränderung des Pegels des ihm zugeführten Signals sofort eine weitere Veränderung erfolgt, für eine weitere Taktsignalperiode in dem Zustand gehalten wird, in welchem er eine hohe Treiberstärke aufweist, bzw.
   - dann, wenn nach der Veränderung des Pegels des ihm zugeführten und von ihm auszugebenden Signals nicht sofort eine weitere Veränderung erfolgt, wieder in einen Zustand versetzt wird, in welchem er eine geringe Treiberstärke aufweist, und in diesem Zustand gehalten wird, bis wieder eine Veränderung des Pegels des ihm zugeführten und von ihm auszugebenden Signals erfolgt.

Veränderungen des Pegels des dem Treiber P zugeführten und von diesem auszugebenden Signals sind sowohl Veränderungen vom niedrigen Pegel auf den hohen Pegel als auch Veränderungen vom hohen Pegel auf den niedrigen Pegel.

Das Umschalten des Treibers P von der niedrigen Treiberstärke auf die hohe Treiberstärke kann beispielsweise dadurch erfolgen, daß im Treiber P ein zusätzlicher Treibertransistor aktiviert wird; das Umschalten des Treibers P von der hohen Treiberstärke auf die niedrige Treiberstärke kann beispielsweise dadurch erfolgen, daß der zusätzliche Treibertransistor wieder deaktiviert wird.

Die hohe Treiberstärke ist so groß bemessen, daß das vom Treiber P ausgegebene Signal, insbesondere die darin enthaltenen Flanken einen wunschgemäßen zeitlichen Verlauf aufweisen.

Daß der Treiber P nur dann die hohe Treiberstärke aufweist, wenn das von ihm auszugebende Signal seinen Pegel ändert, hat keine nachteiligen Auswirkungen auf die Funktion des Treibers. Hohe Treiberstärken werden nämlich nur während Pegeländerungen benötigt; zu allen anderen Zeiten kommt der Treiber auch mit erheblich geringeren Treiberstärken aus.

Durch den Umstand, daß der Treiber P automatisch immer dann, wenn keine hohe Treiberstärke erforderlich ist, in einen Zustand versetzt wird, in welchem er eine niedrige Treiberstärke aufweist, sinkt der Energieverbrauch der Treiberschaltung.

In der Figur 2 ist eine in einigen Punkten modifizierte Treiberschaltung gezeigt. Die in der Figur 2 gezeigte Treiberschaltung enthält einen Treiber P, ein erstes Flip-Flop OUT-FF, ein XOR-Gatter XOR, ein UND-Gatter AND, ein zweites Flip-Flop CTRL-FF, ein drittes Flip-Flop CTRL2-FF, und ein ODER-Gatter OR.

Der Kern der gezeigten Treiberschaltung ist wiederum der Treiber P. Dieser bekommt vom ersten Flip-Flop OUT-FF ein in der Figur 2 mit DAT_OUT bezeichnetes Signal zugeführt, erzeugt daraus ein identisches, aber zum Treiben größerer Lasten geeignetes Signal, und gibt dieses aus. Die restlichen Komponenten der Treiberschaltung, d.h. das XOR-Gatter XOR, das UND-Gatter AND, das zweite Flip-Flop CTRL-FF, das dritte Flip-Flop CTRL2-FF, und das ODER-Gatter OR bilden eine Steuervorrichtung, welche den Treiber P, genauer gesagt dessen Stärke abhängig vom Verlauf des diesem zugeführten Signals DAT_OUT steuern.

Dem ersten Flip-Flop OUT-FF wird ein digitales Eingangssignal DAT_IN zugeführt, welches vom ersten Flip-Flop OUT-FF mit der steigenden oder der fallenden Flanke eines ersten Taktsignals CLK übernommen und als das bereits erwähnte Signal DAT_OUT an den Treiber P ausgegeben wird. Die Signale DAT_IN und DAT_OUT werden darüber hinaus dem XOR-Gatter XOR als Eingangssignale zugeführt. Das XOR-Gatter unterzieht die ihm zugeführten Signale einer XOR-Verknüpfung und gibt das Ergebnis an das UND-Gatter AND aus. Dem UND-Gatter AND wird als zweites Eingangssignal ein Signal ACTIVATE zugeführt wird, durch welches die Modifizierung der Treiberstärke aktivierbar (ACTIVATE = 1) bzw. deaktivierbar (ACTIVATE = 0) ist. Das UND-Gatter AND unterzieht die ihm zugeführten Signale einer UND-Verknüpfung und gibt das Ergebnis an das zweite Flip-Flop CTRL-FF aus. Das zweite Flip-Flop CTRL-FF übernimmt das ihm vom UND-Gatter AND zugeführte Signal mit der steigenden oder der fallenden Flanke des ersten Taktsignals CLK und leitet das Ergebnis an das ODER-Gatter OR und das dritte Flip-Flop CTRL2-FF weiter. Das dritte Flip-Flop CTRL2-FF übernimmt das ihm vom ersten Flip-Flop CTRL-FF zugeführte Signal mit der steigenden oder der fallenden Flanke eines zweiten Taktsignals CLK2 und leitet es an das ODER-Gatter OR weiter. Das ODER-Gatter OR unterzieht die ihm zugeführten Signale einer ODER-Verknüpfung und gibt das Ergebnis als ein den Treiber P steuerndes Signal STRONG_DRIVER an den Treiber P aus.

Wie aus den vorstehenden Erläuterungen ersichtlich ist, stimmen die Treiberschaltung gemäß Figur 1 und die Treiberschaltung gemäß Figur 2 in großen Teilen überein; die Komponenten und Signale der Treiberschaltungen gemäß Figur 1 und Figur 2, die mit den selben Bezugszeichen bezeichnet sind, sind identische oder einander entsprechende Komponenten bzw. Signale. Die Treiberschaltung gemäß Figur 2 weist jedoch zusätzlich das UND-Gatter AND, das dritte Flip-Flop CTRL2-FF, das ODER-Gatter OR, das Signal ACTIVATE, und das zweite Taktsignal CLK2 auf,
- wobei das UND-Gatter AND und das Signal ACTIVATE eine Aktivierung (ACTIVATE = 1) und Deaktivierung (ACTIVATE = 0) der den Treiber P steuernden Steuervorrichtung ermöglichen, und
- wobei durch das dritte Flip-Flop CTRL2-FF, das ODER-Gatter OR, und das zweite Taktsignal CLK2 bewirkt wird, daß der Zeitpunkt, zu welchem der Treiber aus einem Zustand, in welchem er eine hohe Treiberstärke aufweist, in einen Zustand zurückversetzt wird, in welchem er wieder eine niedrige Treiberstärke aufweist, nach hinten verschoben ist, genauer gesagt - abhängig von der Phasenlage des zweiten Taktsignals CLK2 bezüglich des ersten Taktsignals CLK - um bis zu eine Taktperiode des zweiten Taktsignals CLK2 nach hinten verschoben ist, was den positiven Effekt hat, daß sich auf dem den Treiber P steuernden Signal STRONG_DRIVER keine Spikes bilden können.

Die Funktion der Treiberschaltung gemäß Figur 2 entspricht im übrigen der Funktion der Treiberschaltung gemäß Figur 1.

Die selben Effekte würden sich einstellen, wenn das dritte Flip-Flop CTRL2-FF durch ein Schieberegister ersetzt werden würde, welches das vom zweiten Flip-Flop CTRL-FF erhaltene Signal im Takt des zweiten Taktsignals CLK2 übernimmt und weiterschiebt, und dessen Elemente den jeweils aktuellen Inhalt derselben an das ODER-Gatter OR ausgeben.

Bei den unter Bezugnahme auf die Figuren 1 und 2 beschriebenen Treiberschaltungen
- wird der Treiber P zeitgleich mit dem Beginn einer Veränderung des zu treibenden Signals in einen Zustand versetzt, in welchem er eine hohe Treiberstärke aufweist, und
- wird der Treiber P in einen Zustand zurückversetzt, in welchem er eine niedrige Treiberstärke aufweist, nachdem die Veränderung des Wertes des zu treibenden Signals abgeschlossen ist.

Durch eine entsprechende Modifikation der Treiberschaltungen kann auch vorgesehen werden, daß der Treiber P bereits vor dem Zeitpunkt, zu welchem sich das zu treibende Signal zu verändern beginnt, oder erst nach dem Zeitpunkt, zu welchem sich das zu treibende Signal zu verändern beginnt, in einen Zustand versetzt wird, in welchem er eine hohe Treiberstärke aufweist.

Unabhängig hiervon kann - ebenfalls durch eine entsprechende Modifikation der Treiberschaltung - auch vorgesehen werden, daß das Zurückversetzen des Treibers in einen Zustand, in welchem er eine niedrige Treiberstärke aufweist, genau dann erfolgt, wenn die Veränderung des Wertes des zu treibenden Signals gerade abgeschlossen ist, oder daß das Zurückversetzen des Treibers in einen Zustand, in welchem er eine niedrige Treiberstärke aufweist, erfolgt, bevor die Veränderung des Wertes des zu treibenden Signals abgeschlossen ist.

Die erwähnten Modifikationen der Treiberschaltungen können beispielsweise darin bestehen, daß für das zweite Flip-Flop CTRL-FF ein anderes Taktsignal (ein Taktsignal mit anderer Taktfrequenz und/oder mit anderer Phasenlage) verwendet wird als für das erste Flip-Flop OUT-FF.

Als besonders günstig erweist es sich, wenn der Treiber P so angesteuert wird, daß er
- erst nach dem Zeitpunkt, zu welchem sich das zu treibende Signal zu verändern beginnt, in einen Zustand versetzt wird, in welchem er eine hohe Treiberstärke aufweist, und
- bereits vor dem Zeitpunkt, zu welchem die Veränderung des Wertes des zu treibenden Signals abgeschlossen ist, in einen Zustand zurückversetzt wird, in welchem er eine niedrige Treiberstärke aufweist.

Dies hat den positiven Effekt daß das vom Treiber P ausgegebene Signal
- zu Beginn einer Veränderung des zu treibenden Signals wegen der dann noch geringen Treiberstärke der Veränderung des zu treibenden Signals langsam folgt,
- dann der Veränderung des zu treibenden Signals aufgrund der hochgesetzten Treiberstärke schnell folgt, und
- schließlich zum Ende der Veränderung des zu treibenden Signals wegen der dann wieder geringen Treiberstärke der Veränderung des zu treibenden Signals langsam folgt.

Dadurch weist das vom Treiber P ausgegebenen Signal keine sprungartigen Veränderungen auf, und werden keine oder nur geringe elektromagnetischen Störungen oder Einbrüche der Versorgungsspannung erzeugt.

Als vorteilhaft erweist es sich im allgemeinen auch, wenn zusätzlich oder alternativ die Erhöhung und/oder die Verringerung der Treiberstärke kontinuierlich oder in mehreren Stufen erfolgt.

Dies läßt sich bei der in der Figur 1 gezeigten Treiberschaltung beispielsweise dadurch realisieren, daß das zweite Flip-Flop CTRL-FF durch ein schnell getaktetes Schieberegister ersetzt wird, welches die vom XOR-Gatters XOR erhaltenen Signale im Takt eines Taktsignals mit höherer Frequenz als CLK übernimmt und weiterschiebt, und dessen Elemente den jeweils aktuellen Inhalt derselben als Steuersignale zur Steuerung des Treibers P an diesen ausgeben, wobei jedes dieser Steuersignale einen eigenen Treibertransistor innerhalb des Treibers P aktivieren und deaktivieren kann.

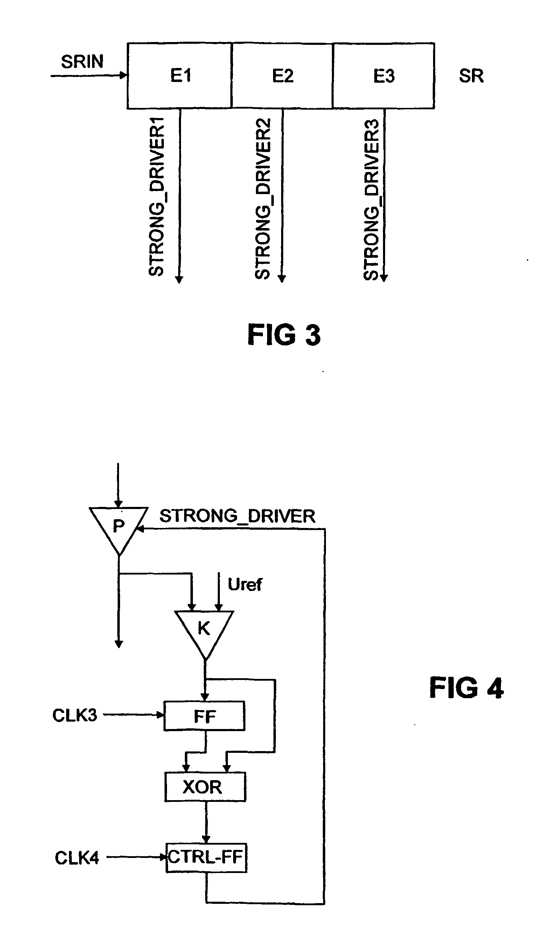

Ein solches Schieberegister ist beispielhaft in Figur 3 veranschaulicht. Dabei bezeichnen SR das Schieberegister, E1 bis E3 die Schieberegisterelemente, SRIN das dem Schieberegister SR vom XOR-Gatter zugeführte Eingangssignal, und STRONG_DRIVER1 bis STRONG_DRIVER3 die vom Schieberegister erzeugten Steuersignale zur Steuerung des Treibers.

Bei den vorstehend beschriebenen Treiberschaltungen war das vom Treiber P zu treibende Signal das Ausgangssignal eines Flip-Flops, genauer gesagt das Ausgangssignal des Flip-Flops OUT-FF. Eine wie beschrieben erfolgende Steuerung des Treibers P kann aber auch durchgeführt werden, wenn dies nicht der Fall ist, also wenn das zu treibende Signal beispielsweise das Ausgangssignal einer kombinatorischen Logik oder einer sonstigen dem Treiber vorgeschalteten Einrichtung ist. In diesem Fall kann basierend auf einer Veränderung der Eingangssignale dem Treiber vorgeschalteten Einrichtung und/oder basierend auf dem Wert eines Enable-Signals, welches den Treiber P und/oder die diesem vorgeschaltete Einrichtung aktiviert oder deaktiviert, ermittelt werden, ob überhaupt ein Signal zu treiben ist, und ob sich das zu treibende Signal ändern wird oder ändern kann, und abhängig hiervon die Treiberstärke des Treibers P variiert.

Die Steuerung des Treibers könnte auch vom Verlauf des Ausgangssignals des Treibers P abhängig gemacht werden. Dies könnte beispielsweise dadurch geschehen,
- daß das Ausgangssignal des Treibers P einem Komparator zugeführt wird, welcher das Signal 1 ausgibt, wenn das vom Treiber P ausgegebene Signal einen nahe beim dem den Pegel 0 repräsentierenden Potential liegenden ersten Schwellenwert überschreitet, und welcher das Signal 0 ausgibt, wenn das vom Treiber P ausgegebene Signal eine nahe beim dem den Pegel 1 repräsentierenden Potential liegenden zweiten Schwellenwert unterschreitet,
- daß das Ausgangssignal des Komparators einem Flip-Flop zugeführt wird, und
- daß durch eine Gegenüberstellung des Eingangssignals und des Ausgangssignals des Flip-Flops ermittelt wird, ob das Ausgangssignal des Treibers sich gerade ändert, wobei die Auswertung des Eingangssignals und des Ausgangssignals des Flip-Flops wie die Auswertung des Eingangssignals und des Ausgangssignals des zweiten Flip-Flops OUT-FF der Treiberschaltung gemäß Figur 1, also unter Verwendung eines XOR-Gatters und eines zweiten Flip-Flops erfolgt.

Eine solche Treiberschaltung ist in Figur 4 gezeigt, wobei das Bezugszeichen P den Treiber bezeichnet, K den Komparator, FF das erste Flip-Flop, XOR das XOR-Gatter, und CTRL-FF das zweite Flip-Flop.

Auf die selbe Art und Weise, wie Veränderungen des Ausgangssignals des Treibers erkannt und behandelt werden, können auch Veränderungen des Eingangssignals des Treibers erkannt und behandelt werden.

Die Ermittlung, ob sich das zu treibende Signal und/oder das vorm Treiber ausgegebene Signal verändert, kann auch durch eine Kombination der vorstehend beschriebenen Maßnahmen erfolgen.

Die beschriebenen Treiberschaltungen ermöglichen es unabhängig von den Einzelheiten der praktischen Realisierung, den darin enthaltenen Treiber so anzusteuern, daß dessen Energieverbrauch und/oder die durch diesen verursachten Störungen auf ein Minimum reduzierbar sind. Die Realisierung der den Treiber steuernden Steuervorrichtung durch eine digitale Schaltung ermöglicht es darüber hinaus, das Auftreten von Glitches bzw. Spikes in dem den Treiber steuernden Signal zuverlässig zu verhindern, und die Steuervorrichtung schnell und einfach zu testen.

### Bezugszeichenliste

- ACTIVATE: Aktivierungssignal
- AND: UND-Gatter
- CLK: Taktsignal
- CLKx: Taktsignal
- CTRL-FF: Flip-Flop
- CTRL2-FF: Flip-Flop
- DAT_IN: zu treibendes Signal
- DAT_OUT: zu treibendes Signal
- Ex: Schieberegister-Element
- FF: Flip-Flop
- K: Komparator
- OR: ODER-Gatter
- OUT-FF: Flip-Flop
- P: Treiber
- SR: Schieberegister
- SRIN: Eingangssignal von SR
- STRONG_DRIVER: Steuersignal
- XOR: XOR-Gatter

## Patentansprüche

1. Treiberschaltung mit einem Treiber (P) und einer den Treiber steuernden Steuervorrichtung (XOR, CTRL-FF; XOR, AND, CTRL-FF, CTRL2-FF, OR), wobei die Steuervorrichtung die Stärke des Treibers abhängig vom Verlauf des durch den Treiber zu treibenden Signals (DAT_OUT) modifiziert,
**dadurch gekennzeichnet,**
**daß** in der Leitung, über welche dem Treiber das zu treibende signal zugeführt wird, ein Flip-Flop (OUT-FF) vorgesehen ist, welches das zu treibende Signal mit der steigenden oder fallenden Flanke eines Taktsignales (CLK) übernimmt und an den Treiber ausgibt, und
**daß** die Steuervorrichtung mit dem Eingangsanschluß und dem Ausgangsanschluß des Flip-Flops verbunden ist und die Stärke des Treibers abhängig von den am Eingangsanschluß und am Ausgangsanschluß des Flip-Flops anliegenden Signalen modifiziert.

2. Treiberschaltung nach Anspruch 1,
**dadurch gekennzeichnet,**
**daß** das zu treibende Signal (DAT_OUT) ein digitales Signal ist.

3. Treiberschaltung nach Anspruch 1 oder 2,
**dadurch gekennzeichnet,**
**daß** die Steuervorrichtung (XOR, CTRL-FF; XOR, AND, CTRL-FF, CTRL2-FF, OR) zumindest teilweise eine digitale Schaltung ist.

4. Treiberschaltung nach einem der vorhergehenden Ansprüche,
**dadurch gekennzeichnet,**
**daß** die Steuervorrichtung (XOR, CTRL-FF; XOR, AND, CTRL-FF, CTRL2-FF, OR) eine zumindest teilweise taktgesteuerte Schaltung ist.

5. Treiberschaltung nach einem der vorhergehenden Ansprüche,
**dadurch gekennzeichnet,**
**daß** die Steuervorrichtung (XOR, CTRL-FF; XOR, AND, CTRL-FF, CTRL2-FF, OR) überprüft, ob das zu treibende Signal (DAT_OUT) seinen Wert ändert, ändern wird oder ändern kann, und dann, wenn dieser Fall ist, die Stärke des Treibers (P) modifiziert.

6. Treiberschaltung nach Anspruch 5,
**dadurch gekennzeichnet,**
**daß** die Steuervorrichtung (XOR, CTRL-FF; XOR, AND, CTRL-FF, CTRL2-FF, OR) davon ausgeht, daß das zu treibende Signal (DAT_OUT) seinen Wert ändert, ändern wird, oder ändern kann, wenn sich das Eingangssignal (DAT_IN) und das Ausgangssignal (DAT_OUT) des vom zu treibenden Signal durchflossenen Flip-Flops (OUT-FF) unterscheiden.

7. Treiberschaltung nach Anspruch 5,
**dadurch gekennzeichnet,**
**daß** die Steuervorrichtung (XOR, CTRL-FF; XOR, AND, CTRL-FF, CTRL2-FF, OR) davon ausgeht, daß das zu treibende Signal (DAT_OUT) seinen Wert ändert, ändern wird, oder ändern kann, wenn ein Enable-Signal, durch welches der Treiber und/oder eine dem Treiber vorgeschaltete Einrichtung aktivierbar und deaktivierbar sind, einen bestimmten Wert hat.

8. Treiberschaltung nach einem der vorhergehenden Ansprüche,
**dadurch gekennzeichnet,**
**daß** die Steuervorrichtung (XOR, CTRL-FF; XOR, AND, CTRL-FF, CTRL2-FF, OR) dann, wenn das zu treibende Signal (DAT_OUT) seinen Wert ändert, ändern wird, oder ändern kann, den Treiber in einen Zustand versetzt, in welchem er eine höhere Treiberstärke aufweist als es sonst der Fall ist.

9. Treiberschaltung nach Anspruch 8,
**dadurch gekennzeichnet,**
**daß** das Versetzen des Treibers (P) in einen Zustand, in welchem er eine höhere Treiberstärke aufweist, erfolgt, bevor das zu treibende Signal (DAT_OUT) seinen Wert zu ändern beginnt oder zu ändern beginnen könnte.

10. Treiberschaltung nach Anspruch 8,
**dadurch gekennzeichnet,**
**daß** das Versetzen des Treibers (P) in einen Zustand, in welchem er eine höhere Treiberstärke aufweist, genau dann erfolgt, wenn das zu treibende Signal (DAT_OUT) seinen Wert zu ändern beginnt oder zu ändern beginnen könnte.

11. Treiberschaltung nach Anspruch 8,
**dadurch gekennzeichnet,**
**daß** das Versetzen des Treibers (P) in einen Zustand, in welchem er eine höhere Treiberstärke aufweist, erfolgt, nachdem das zu treibende Signal (DAT_OUT) seinen Wert zu ändern beginnt oder zu ändern beginnen könnte.

12. Treiberschaltung nach einem der Ansprüche 8 bis 11,
**dadurch gekennzeichnet,**
**daß** die Steuervorrichtung (XOR, CTRL-FF; XOR, AND, CTRL-FF, CTRL2-FF, OR) den Treiber (P) so ansteuert, daß die Treiberstärke in aufeinanderfolgenden Schritten stufenweise erhöht wird.

13. Treiberschaltung nach einem der Ansprüche 8 bis 12,
**dadurch gekennzeichnet,**
**daß** die Steuervorrichtung (XOR, CTRL-FF; XOR, AND, CTRL-FF, CTRL2-FF, OR) dann, wenn das zu treibende Signal (DAT_OUT) nach der Erhöhung der Treiberstärke seinen Wert nicht erneut ändert, ändern wird, oder ändern kann, den Treiber in einen Zustand zurückversetzt, in welchem er eine niedrige Treiberstärke aufweist.

14. Treiberschaltung nach Anspruch 13,
**dadurch gekennzeichnet,**
**daß** das Zurückversetzen des Treibers (P) in einen Zustand, in welchem er eine niedrige Treiberstärke aufweist, erfolgt, nachdem die Veränderung des Wertes des zu treibenden Signals (DAT_OUT) abgeschlossen ist oder abgeschlossen sein könnte.

15. Treiberschaltung nach Anspruch 13,
**dadurch gekennzeichnet,**
**daß** das Zurückversetzen des Treibers (P) in einen Zustand, in welchem er eine niedrige Treiberstärke aufweist, genau dann erfolgt, wenn die Veränderung des Wertes des zu treibenden Signals (DAT_OUT) abgeschlossen ist oder abgeschlossen sein könnte.

16. Treiberschaltung nach Anspruch 13,
**dadurch gekennzeichnet,**
**daß** das Zurückversetzen des Treibers (P) in einen Zustand, in welchem er eine niedrige Treiberstärke aufweist, erfolgt, bevor die Veränderung des Wertes des zu treibenden Signals (DAT_OUT) abgeschlossen ist oder abgeschlossen sein könnte.

17. Treiberschaltung nach einem der Ansprüche 13 bis 16,
**dadurch gekennzeichnet,**
**daß** die Steuervorrichtung (XOR, CTRL-FF; XOR, AND, CTRL-FF, CTRL2-FF, OR) den Treiber (P) so ansteuert, daß die Treiberstärke in aufeinanderfolgenden Schritten stufenweise verringert wird.

18. Treiberschaltung nach einem der vorhergehenden Ansprüche,
**dadurch gekennzeichnet,**
**daß** die Steuervorrichtung (XOR, CTRL-FF; XOR, AND, CTRL-FF, CTRL2-FF, OR) dann, wenn das zu treibende Signal (DAT_OUT) seinen Wert nicht ändert, nicht ändern wird, oder nicht ändern kann, den Treiber in einem Zustand hält, in welchem er eine niedrige Treiberstärke aufweist.

## Claims

1. Driver circuit comprising a driver (P) and a control device (XOR, CTRL-FF, XOR; AND; CTRL-FF, CTRL2-FF, OR) for controlling the driver, the control device modifying the power of the driver on the basis of the waveform of the signal (DAT_OUT) to be driven by the driver,
**characterized**
**in that** a flip-flop (OUT-FF) is provided in the line via which the signal to be driven is fed to the driver, accepts the signal to be driven with the rising or falling flank of a clock signal (CLK) and outputs the said signal to the driver, and
**in that** the control device is connected to the input terminal and the output terminal of the flip-flop and modifies the power of the driver as a function of the signals present on the input terminal and on the output terminal of the flip-flop.

2. Driver circuit according to Claim 1, **characterized in that** the signal (DAT_OUT) to be driven is a digital signal.

3. Driver circuit according to Claim 1 or 2, **characterized**
**in that** the control device (XOR, CTRL-FF; XOR, AND, CTRL-FF, CTRL2-FF, OR) is at least partly a digital circuit.

4. Driver circuit according to one of the preceding claims, **characterized in that** the control device (XOR, CTRL-FF; XOR, AND, CTRL-FF, CTRL2-FF, OR) is an at least partly clock-controlled circuit.

5. Driver circuit according to one of the preceding claims, **characterized in that** the control device (XOR, CTRL-FF; XOR, AND, CTRL-FF, CTRL2-FF, OR) checks whether the signal (DAT_OUT) to be driven changes its value, will change its value or can change its value and, if this is the case, modifies the power of the driver (P).

6. Driver circuit according to Claim 5, **characterized in that** the control device (XOR, CTRL-FF; XOR, AND, CTRL-FF, CTRL2-FF, OR) assumes that the signal (DAT_OUT) to be driven changes its value, will change its value or can change its value when the input signal (DAT_IN) and the output signal (DAT_OUT) from a flip-flop (OUT-FF), through which the signal to be driven flows, differ.

7. Driver circuit according to Claim 5, **characterized in that** the control device (XOR, CTRL-FF; XOR, AND, CTRL-FF, CTRL2-FF, OR) assumes that the signal (DAT_OUT) to be driven changes its value, will change its value or can change its value when an enable signal, by means of which the driver and/or a device connected upstream of the driver can be activated and deactivated, has a specific value.

8. Driver circuit according to one of the preceding claims, **characterized in that**, when the signal (DAT_OUT) to be driven changes its value, will change its value or can change its value, the control device (XOR, CTRL-FF; XOR, AND, CTRL-FF, CTRL2-FF, OR) sets the driver into a state in which it has a higher driver power than is otherwise the case.

9. Driver circuit according to Claim 8, **characterized in that** the driver (P) is set into a state in which it has a higher driver power before the signal (DAT_OUT) to be driven begins to change its value or could begin to change its value.

10. Driver circuit according to Claim 8, **characterized in that** the driver (P) is set into a state in which it has a higher driver power precisely when the signal (DAT_OUT) to be driven begins to change its value or could begin to change its value.

11. Driver circuit according to Claim 8, **characterized in that** the driver (P) is set into a state in which it has a higher driver power after the signal (DAT_OUT) to be driven begins to change its value or could begin to change its value.

12. Driver circuit according to one of Claims 8 to 11, **characterized in that** the control device (XOR, CTRL-FF; XOR, AND, CTRL-FF, CTRL2-FF, OR) drives the driver (P) in such a way that the driver power is increased step by step in successive steps.

13. Driver circuit according to one of Claims 8 to 12, **characterized in that**, when the signal (DAT_OUT) to be driven does not change its value again, will not change its value again or cannot change its value again following the increase in the driver power, the control device (XOR, CTRL-FF; XOR, AND, CTRL-FF, CTRL2-FF, OR) resets the driver into a state in which it has a low driver power.

14. Driver circuit according to Claim 13, **characterized in that** the driver (P) is reset into a state in which it has a low driver power after the change in the value of the signal (DAT_OUT) to be driven has been completed or could have been completed.

15. Driver circuit according to Claim 13, **characterized in that** the driver (P) is reset into a state in which it has a low driver power exactly when the change in the value of the signal (DAT_OUT) to be driven has been completed or could have been completed.

16. Driver circuit according to Claim 13, **characterized in that** the driver (P) is reset into a state in which it has a low driver power before the change in the value of the signal (DAT_OUT) to be driven has been completed or could have been completed.

17. Driver circuit according to one of Claims 13 to 16, **characterized in that** the control device (XOR, CTRL-FF; XOR, AND, CTRL-FF, CTRL2-FF, OR) drives the driver (P) in such a way that the driver power is reduced step by step in successive steps.

18. Driver circuit according to one of the preceding claims, **characterized in that**, when the signal (DAT_OUT) to be driven does not change its value, will not change its value or cannot change its value, the control device (XOR, CTRL-FF; XOR, AND, CTRL-FF, CTRL2-FF, OR) keeps the driver in a state in which it has a low driver power.

## Revendications

1. Circuit d'excitation comprenant un excitateur (P) et un dispositif de commande (XOR, CTRL-FF ; XOR, AND , CTRL-FF , CTRL2-FF , OR) commandant l'excitateur, le dispositif de commande modifiant l'intensité de l'excitateur en fonction de la courbe du signal (DAT_OUT) à exciter par l'excitateur,
**caractérisé en ce que**
dans la ligne, par laquelle le signal à exciter est amené à l'excitateur, il est prévu un flip-flop (OUT_FF) qui prend en charge le signal à exciter avec le flanc croissant ou décroissant d'un signal de synchronisation (CLK) et l'envoie à l'excitateur et
**en ce que** le dispositif de commande est relié au branchement d'entrée et au branchement de sortie du flip-flop et modifie l'intensité de l'excitateur en fonction des signaux s'appliquant sur le branchement d'entrée et sur le branchement de sortie du flip-fop.

2. Circuit d'excitation selon la revendication 1,
**caractérisé en ce que**
le signal à exciter (DAT_OUT) est un signal numérique.

3. Circuit d'excitation selon la revendication 1 ou 2,
**caractérisé en ce que**
le dispositif de commande (XOR, CTRL-FF ; XOR, AND, CTRL-FF , CTRL2-FF , OR) est au moins en partie un circuit numérique.

4. Circuit d'excitation selon l'une quelconque des revendications précédentes,
**caractérisé en ce que**
le dispositif de commande (XOR, CTRL-FF ; XOR, AND , CTRL-FF , CTRL2-FF , OR) est un circuit commandé au moins partiellement par rythme.

5. Circuit d'excitation selon l'une quelconque des revendications précédentes,
**caractérisé en ce que**
le dispositif de commande (XOR, CTRL-FF ; XOR, AND, CTRL-FF , CTRL2-FF , OR) vérifie si le signal à exciter (DAT_OUT) modifie, modifiera ou peut modifier sa valeur et, lorsque c'est le cas, modifie l'intensité de l'excitateur (P).

6. Circuit d'excitation selon la revendication 5,
**caractérisé en ce que**
le dispositif de commande (XOR, CTRL-FF ; XOR, AND, CTRL-FF , CTRL2-FF , OR) part du principe que le signal (DAT_OUT) à exciter modifie, modifiera ou peut modifier sa valeur lorsque le signal d'entrée (DAT_IN) et le signal de sortie (DAT_OUT) du flip-flop (OUT_FF) traversé par le signal à exciter se différencient.

7. Circuit d'excitation selon la revendication 5,
**caractérisé en ce que**
le dispositif de commande (XOR, CTRL-FF ; XOR, AND, CTRL-FF , CTRL2-FF , OR) part du principe que le signal à exciter (DAT_OUT) modifie, modifiera ou peut modifier sa valeur lorsque un signal Enable, par lequel l'excitateur et/ou un dispositif placé en amont de l'excitateur peuvent être activés et désactivés, a une valeur définie.

8. Circuit d'excitation selon l'une quelconque des revendications précédentes,
**caractérisé en ce que**
le dispositif de commande (XOR, CTRL-FF ; XOR, AND, CTRL-FF , CTRL2-FF , OR) met l'excitateur dans un état où il présente une intensité d'excitateur plus élevée que dans le cas habituel dans les cas où le signal à exciter (DAT_OUT) modifie, modifiera ou peut modifier sa valeur.

9. Circuit d'excitation selon la revendication 8,
**caractérisé en ce que**
le déplacement de l'excitateur (P) dans un état où il présente une intensité d'excitateur plus élevée intervient avant que le signal à exciter (DAT_OUT) commence à modifier sa valeur ou puisse commencer à modifier sa valeur.

10. Circuit d'excitation selon la revendication 8,
**caractérisé en ce que**
le déplacement de l'excitateur (P) dans un état où il présente une intensité d'excitateur plus élevée intervient exactement au moment où le signal à exciter (DAT_OUT) commence à modifier sa valeur ou pourrait commencer à modifier sa valeur.

11. Circuit d'excitation selon la revendication 8,
**caractérisé en ce que**
le déplacement de l'excitateur (P) dans un état où il présente une intensité d'excitateur plus élevée intervient une fois que le signal à exciter (DAT_OUT) commence à modifier sa valeur ou pourrait commencer à modifier sa valeur.

12. Circuit d'excitation selon l'une quelconque des revendications 8 à 11,
**caractérisé en ce que**
le dispositif de commande (XOR, CTRL-FF ; XOR, AND, CTRL-FF , CTRL2-FF , OR) active l'excitateur (P) de telle sorte que l'intensité de l'excitateur est augmentée progressivement par étapes successives.

13. Circuit d'excitation selon l'une quelconque des revendications 8 à 12,
**caractérisé en ce que**
le dispositif de commande (XOR, CTRL-FF ; XOR, AND, CTRL-FF , CTRL2-FF , OR) ramène l'excitateur dans un état où il présente une faible intensité d'excitateur dans les cas où le signal à exciter (DAT_OUT) ne modifie pas, ne modifiera pas ou ne peut pas modifier à nouveau sa valeur après l'augmentation de l'intensité de l'excitateur.

14. Circuit d'excitation selon la revendication 13,
**caractérisé en ce que**
le recul de l'excitateur (P) dans un état où il présente une faible intensité d'excitateur intervient une fois que la modification de la valeur du signal à exciter (DAT_OUT) est terminée ou pourrait être terminée.

15. Circuit d'excitation selon la revendication 13,
**caractérisé en ce que**
le recul de l'excitateur (P) dans un état où il présente une faible intensité d'excitateur intervient précisément dans les cas où la modification de la valeur du signal à exciter (DAT_OUT) est terminée ou pourrait être terminée.

16. Circuit d'excitation selon la revendication 13,
**caractérisé en ce que**
le recul de l'excitateur (P) dans un état où il présente une faible intensité d'excitateur intervient avant que la modification de la valeur du signal à exciter (DAT_OUT) soit terminée ou puisse être terminée.

17. Circuit d'excitation selon l'une quelconque des revendications 13 à 16,
**caractérisé en ce que**
le dispositif de commande (XOR, CTRL-FF ; XOR, AND , CTRL-FF , CTRL2-FF , OR) active l'excitateur (P) de telle sorte que l'intensité d'excitateur est réduite progressivement par étapes successives.

18. Circuit d'excitation selon l'une quelconque des revendications précédentes,
**caractérisé en ce que**
le dispositif de commande (XOR, CTRL-FF ; XOR, AND, CTRL-FF , CTRL2-FF , OR) maintient l'excitateur dans un état où il présente une faible intensité d'excitateur dans les cas où le signal à exciter (DAT_OUT) ne modifie pas, ne modifiera pas ou ne peut pas modifier sa valeur.
